(19) Europäisches Patentamt / European Patent Office / Office européen des brevets

(11) **EP 2 686 955 B1**

(12) **FASCICULE DE BREVET EUROPEEN**

(45) Date de publication et mention
de la délivrance du brevet:
**27.05.2015 Bulletin 2015/22**

(21) Numéro de dépôt: **12714770.0**

(22) Date de dépôt: **14.03.2012**

(51) Int Cl.:
**H03H 17/02** *(2006.01)*

(86) Numéro de dépôt international:
**PCT/FR2012/050526**

(87) Numéro de publication internationale:
**WO 2012/123676 (20.09.2012 Gazette 2012/38)**

(54) **PROCEDE ET DISPOSITIF DE FILTRAGE LORS D'UN CHANGEMENT DE FILTRE ARMA**

VERFAHREN UND VORRICHTUNG ZUR FILTERUNG WÄHREND EINER ÄNDERUNG BEI EINEM ARMA-FILTER

METHOD AND DEVICE FOR FILTERING DURING A CHANGE IN AN ARMA FILTER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.03.2011 FR 1152198**

(43) Date de publication de la demande:
**22.01.2014 Bulletin 2014/04**

(73) Titulaire: **Orange**
**75015 Paris (FR)**

(72) Inventeurs:
• **GUERIN, Alexandre**
**F-35200 Rennes (FR)**
• **FAURE, Julien**
**F-22300 Ploubezre (FR)**
• **MARRO, Claude**
**F-22220 Plouguiel (FR)**

(74) Mandataire: **Regimbeau**
**20, rue de Chazelles**
**75847 Paris Cedex 17 (FR)**

(56) Documents cités:
**EP-A1- 2 144 171    WO-A1-97/39526**
**US-A- 4 706 291    US-A- 5 698 807**

• **VERHELST W ET AL: "A modified-superposition speech synthesizer and its application", ICASSP 86 IEEE-IECEJ-ASJ INTERNATIONAL CONFERENCE ON ACOUSTICS, SPEECH AND SIGNAL PROCESSING, TOKYO, JAPAN, 7 avril 1986 (1986-04-07), - 11 avril 1986 (1986-04-11), pages 2007-2010, XP002663970, ICASSP 86 Proceedings. IEEE-IECEJ-ASJ International Conference on Acoustics, Speech and Signal Processing (Cat. No.86CH2243-4) IEEE New York, NY, USA**
• **ZETTERBERG L H ET AL: "Elimination of transients in adaptive filters with application to speech coding", SIGNAL PROCESSING, vol. 15, no. 4, 1 décembre 1988 (1988-12-01), pages 419-428, XP026672203, ELSEVIER SCIENCE PUBLISHERS B.V. AMSTERDAM, NL ISSN: 0165-1684, DOI: 10.1016/0165-1684(88)90060-6 [extrait le 1988-12-01]**

**Description**

La présente invention concerne un procédé de filtrage de signaux numériques à l'aide d'au moins un filtre autorégressif à moyenne ajustée, autrement connu sous l'appellation ARMA (Auto-Regressive Moving Averaged) et un dispositif correspondant.

Elle vise notamment le filtrage lors de la modification du filtre ARMA dans le temps (extinction ou activation par exemple) ou lors d'un changement de filtre ARMA.

Un domaine d'application principal est celui des signaux numériques audio.

De façon connue en soi, un filtre ARMA linéaire peut être représenté sous forme d'une fonction de transfert H(z), liant, dans un domaine de transformées en z, le signal d'entrée X(z) et le signal filtré de sortie Y(z) par:

$$Y(z) = H(z).X(z) = \frac{b_1 + b_2.z^{-1} + ... + b_{n+1}.z^{-n}}{a_1 + a_2.z^{-1} + ... + a_{m+1}.z^{-m}}.X(z) = \frac{B(z)}{A(z)}.X(z)$$

.

Le polynôme B(z) définit la partie moyenne mobile (ou *Moving Average* MA) du filtre ARMA, et le polynôme A(z) définit la partie autorégressive (AR) du filtre ARMA.

Les filtres à réponse impulsionnelle finie (RIF) correspondent au cas où le degré m du polynôme A est nul.

Les filtres à réponse impulsionnelle infinie (RII, ou IIR pour *Infinite Impulse Response*) correspondent au cas où le degré m du polynôme A est non nul.

Les filtres ARMA variant dans le temps, et en particulier les filtres RII, sont par exemple utilisés dans des logiciels d'édition audio pour changer d'effet dynamiquement (égaliseurs multi-bandes, effets audio, etc.), dans les solutions de synthèse (vocale et autre) ou encore dans les traitements à la prise ou à la restitution du son (réduction ou suppression de bruits dont les caractéristiques varient dans le temps).

La modification au cours du temps de filtres ARMA, et plus particulièrement de filtres RII, présente toutefois des inconvénients, résidant principalement dans l'apparition d'artefacts transitoires lors du changement de filtre. Ces artefacts se manifestent par exemple sous la forme de "clics" audio particulièrement désagréables à l'écoute, et sont par exemple liés à l'initialisation des mémoires internes d'un nouveau filtre RII à activer, au déphasage introduit par le filtre ARMA courant à éteindre, ainsi qu'à de potentielles différences de délai global (délai de groupe) des filtres précités.

Pour la suite, la description se concentrera principalement sur le cas des filtres de type RII, et en particulier linéaires. En effet, les filtres à réponse impulsionnelle infinie sont ceux pour lesquelles un changement de filtre génère classiquement le plus d'artefacts. Par ailleurs, les filtres linéaires s'avèrent être bien plus répandus et étudiés que les filtres non linéaires.

Ainsi, les explications ci-après pourront être appliquées directement dans un large champ de situations classiques.

Néanmoins, il est entendu que l'invention peut s'appliquer à tout type de filtre ARMA, linéaire ou non, et notamment au cas des filtres de Volterra qui sont des filtres polynomiaux non linéaires. La théorie des filtres polynomiaux dits "de Volterra" est notamment documentée au travers de la publication *"The Volterra and Wiener theories of nonlinear systems"* (Schetzen, 1989, Ed. Krieger).

Différentes solutions ont déjà pu être apportées dans les techniques de l'art antérieur pour tenter de limiter, voire de supprimer, les effets transitoires liés aux mémoires internes de ces filtres RII.

Une approche, illustrée par la publication *"Elimination of transients in adaptive filters with application to speech coding"* de Zetterberg, L.H. et Q. Zhang (1988), repose sur l'initialisation des variables d'état internes en mémoires internes du nouveau filtre RII à activer.

Pour procéder à une initialisation correcte, un nombre suffisant d'échantillons précédant le moment de changement de filtre RII est stocké, puis tous ces échantillons sont filtrés par le nouveau filtre RII. Une fois initialisé, le nouveau filtre RII est appliqué au signal.

Les auteurs de cette publication ont montré que, contrairement à la théorie, il est possible de se contenter d'un nombre réduit d'échantillons pour réaliser cette initialisation, malgré le caractère infini des réponses impulsionnelles de ces filtres. Ce nombre dépend directement de la "longueur de la réponse impulsionnelle" du nouveau filtre, notion définie par les LONG premiers échantillons comptant pour x % de l'énergie totale du filtre (le pourcentage x pouvant être déterminé de manière empirique et suivant les applications), dans le cas d'un filtre RII stable dont la queue de réponse impulsionnelle tend vers 0.

Cette approche souffre toutefois de complexité et/ou de latence.

En effet, l'initialisation des variables internes du nouveau filtre RII nécessite de filtrer un nombre d'échantillons N qui dépend de la longueur LONG de la réponse impulsionnelle du filtre: de manière générale, il est nécessaire que N > LONG pour éviter tout artefact audible.

Compte tenu de cette contrainte, deux options de mises en oeuvre sont envisagées :

- soit les variables internes sont initialisées au moment du changement de filtre RII, ce qui nécessite de filtrer N+1 échantillons : les N échantillons précédents l'échantillon courant ainsi que l'échantillon courant. Cela engendre toutefois un pic de complexité très important à l'instant *t* du changement de filtre RII;
- soit il est opéré un filtrage parallèle avec les deux filtres : le basculement entre les deux filtres est alors réalisé au bout de N échantillons. Cette option implique une latence de N échantillons avant l'application du nouveau filtre RII, signifiant que le nouveau filtre n'est appliqué qu'au bout de ces N échantillons. Il en résulte une gêne notable si l'on désire appliquer le plus rapidement possible le nouveau filtre RII au signal (par exemple pour supprimer un signal particulier) ou changer à nouveau de filtre RII avant la fin des N échantillons.

Ces inconvénients existent également lorsqu'il s'agit d'une simple désactivation (extinction) du filtre RII courant (dans ce cas, le "nouveau filtre" peut être vu comme un "filtre identité" laissant tout passer), car le filtre RII courant introduit un déphasage dans le signal filtré, à l'origine de "clics" audio lors de l'extinction brutale du filtre.

Enfin, cette approche ne prémunit pas contre les différences de délai (group delay) entre les deux filtres RII : si les deux filtres ont un délai de groupe différent, cela se traduit inévitablement par un artefact audible (type'clic') lié à la discontinuité du signal.

Une approche hybride a également été envisagée dans la publication *"A modified-superposition speech synthesizer and its applications"* de Verhelst, W. and P. Nilens (1986).

Cette approche met en oeuvre un "technique d'évanouissement" consistant à instancier les deux filtres RII en parallèle au moment du basculement d'un filtre vers l'autre, avec la configuration suivante: le nouveau filtre RII, non initialisé, reçoit le signal à filtrer tandis que l'ancien filtre RII "s'éteint" (par évanouissement) en ne recevant aucune entrée.

La sortie filtrée est alors constituée de la somme des sorties de chacun des deux filtres RII, somme effectuée pendant une durée limitée N. En pratique, le temps "d'interpolation" N (la durée du mixage des sorties) nécessaire pour n'avoir aucun artefact auditif est supérieur aux longueurs LONG des réponses impulsionnelles des deux filtres RII.

Cette approche hybride s'apparente à la deuxième option de mise en oeuvre évoquée ci-dessus pour l'approche avec initialisation des mémoires internes. En effet, il est également fait recours à deux filtres RII fonctionnant en parallèle.

La différence réside cependant dans la transition instantanée entre les deux filtres RII, rendue possible grâce au mixage des deux sorties (plutôt qu'en basculant instantanément d'une sortie d'un filtre à l'autre au bout d'un certain temps dans la deuxième option ci-dessus). Cela permet de limiter les artefacts liés aux différences de délai de groupe entre les filtres RII.

Toutefois, cette approche hybride souffre également des autres inconvénients mentionnés précédemment, et notamment d'une latence due à la durée d'interpolation qui doit rester plus grande que la longueur LONG effective de la réponse impulsionnelle des filtres RII.

De façon similaire, le brevet US 4 706 291 propose un exemple de construction d'un circuit de contrôle de caractéristique fréquentielle, comprenant deux canaux pourvus de circuits de filtre avec différentes caractéristiques fréquentielles, et les caractéristiques fréquentielles sont progressivement modifiées par un fondu enchaîné des caractéristiques fréquentielles de ces circuits de filtre.

Dans ce contexte, la présente invention vise à pallier au moins un des inconvénients précités.

A cet effet, l'invention concerne notamment un procédé de filtrage d'un signal numérique à l'aide d'au moins un filtre ARMA, comprenant une étape de réception d'une première demande de changement de filtrage vers ou depuis un filtrage par un premier filtre RII, **caractérisé en ce qu**'il comprend, en réponse à ladite première demande, une étape de basculement progressif, au niveau de chacun d'une pluralité de premiers blocs filtrants mis en cascade, entre un filtrage de signal numérique par une première cellule élémentaire de filtrage issue d'une factorisation du premier filtre et un filtrage de signal numérique par une autre cellule élémentaire de filtrage associée, et **dans lequel** l'ensemble desdites premières cellules élémentaires de filtrage de la pluralité de premiers blocs filtrants factorise ledit premier filtre ARIIA.

Notamment, le basculement progressif peut prévoir un pilotage inverse entre les premières cellules élémentaires et les autres cellules élémentaires de filtrage, afin par exemple de passer d'un filtrage uniquement par le premier filtre ARMA ou RII (c'est-à-dire par les premières cellules élémentaires) en un filtrage par les autres cellules élémentaires (mettant en oeuvre ensemble par exemple un autre filtre ARMA ou RII ou un filtre identité représentatif de l'absence de filtrage).

La factorisation d'un filtre ARMA, et notamment RII, s'entend d'une décomposition du filtre en cellules élémentaires de filtrage dont l'ensemble des fonctions de transfert correspond à une factorisation de la fonction de transfert dudit filtre ARMA.

Le basculement progressif de filtrage s'entend d'un passage d'un filtrage à un autre, au cours duquel les deux filtrages sont mis en oeuvre ensemble et combinés au moins temporairement, c'est-à-dire pendant un instant non nul (correspondant, en technique de traitement d'un signal numérique, à au moins un échantillon). En d'autres termes, pendant cette phase de basculement progressif, les deux filtrages contribuent en partie à la valeur de sortie du signal filtré par un bloc filtrant.

La présente invention offre des performances améliorées par rapport aux techniques de l'art antérieur, et notamment une latence réduite, due en particulier à un temps d'initialisation des variables internes ou un temps de mise en phase des filtres nettement réduit. En effet, dans le premier cas, la durée d'interpolation nécessaire pour éviter les artefacts auditifs est elle-même réduite.

Cette situation résulte de la mise en oeuvre, selon l'invention, d'une factorisation du ou des filtres ARMA (ou RII) mis en oeuvre en une pluralité de cellules élémentaires de filtrage au sein de blocs filtrants, et d'un contrôle, au niveau de chacun de ceux-ci, du basculement entre filtre(s).

En effet, en raison de la factorisation, les filtres MA et RA des cellules élémentaires de filtrage sont d'ordres inférieurs aux filtres MA et AR correspondants du filtre ARMA d'origine (c'est-à-dire que les polynômes A et B correspondants dans les fonctions de transfert sont de degrés inférieurs). Or le temps d'initialisation des variables internes de filtres d'ordre inférieur est nettement plus court que celui d'un filtre ARMA complet. Le temps d'initialisation réduit est alors obtenu par le basculement progressif de filtrage au niveau de chacune des cellules élémentaires de filtrage (d'ordre inférieur) lors de l'activation du filtre ARMA correspondant.

Il en est de même lors de la simple extinction du filtre ARMA courant.

La présente invention permet ainsi une réactivité accrue, par exemple lorsqu'un nouveau filtre doit être instancié rapidement en réponse à un événement acoustique imprévu. C'est notamment le cas lorsque l'on souhaite supprimer un signal qui apparaît soudainement (un son pur, un signal multifréquence à deux tonalités ou DTMF, etc.) et/ou dont les caractéristiques temporelles/spectrales varient rapidement dans le temps.

On notera qu'un basculement dynamique depuis ou vers un filtre ARMA peut ainsi être réalisé de manière instantanée en appliquant une opération de basculement sur la sortie de chaque cellule élémentaire de filtrage qui sert ensuite d'entrée de la cellule élémentaire suivante (en raison de la mise en cascade desdits premiers blocs filtrants).

Par ailleurs, en raison de l'initialisation plus rapide, un éventuel pic de complexité à l'instant du basculement lié à l'instanciation simultanée de deux filtres est nettement réduit.

Pendant le passage progressif de l'état dans lequel le signal numérique est filtré avant basculement (donc soit uniquement par les premières cellules élémentaires de filtrage factorisant le premier filtre ARMA, soit par les autres cellules élémentaires représentant un autre filtre, "identité" ou non) à l'état dans lequel le signal numérique est filtré après basculement (donc par les autres cellules élémentaires ou par les premières cellules élémentaires), le signal filtré de sortie de chaque bloc filtrant combine ainsi un signal filtré par la première cellule élémentaire et un signal filtré par l'autre cellule élémentaire associée. Par exemple, le basculement progressif au niveau d'un premier bloc filtrant comprend la combinaison, au moins temporaire, d'un signal filtré par la première cellule élémentaire de filtrage avec un signal filtré par l'autre cellule élémentaire de filtrage associée, de sorte à obtenir un signal de sortie mixée de bloc filtrant pendant le basculement progressif.

En d'autres termes, les signaux filtrés par une première cellule élémentaire et par la cellule élémentaires qui lui est associée sont mixés, c'est-à-dire combinés au sein d'un même signal filtré. Le mixage garantit un lissage de la transition entre les états de filtrage, et par conséquent contribue à l'atténuation, voire à la suppression, des artefacts audibles lors d'une telle transition.

Ainsi, un bloc filtrant peut mettre en oeuvre un additionneur (ou mélangeur) venant additionner les contributions résultant des sorties de filtrage des deux cellules élémentaires du bloc. Comme on le verra par la suite, les moyens de contrôle du basculement peuvent être variés, par exemple en faisant varier les contributions de chaque cellule élémentaire par application d'un coefficient progressif de basculement à leur signal de sortie, ou en agissant directement sur le signal d'entrée de ces cellules élémentaires soit par application d'un coefficient de basculement similaire (par exemple dans le cas de cellules linéaires), soit par utilisation d'un interrupteur aiguillant le signal à filtrer vers l'une ou l'autre des cellules élémentaires du bloc. Dans le dernier cas notamment, la cellule élémentaire de filtrage qui est débranchée par l'interrupteur continue de fournir un signal de sortie du fait du temps de réponse impulsionnelle, assurant de la sorte un mixage des signaux de sortie des deux cellules élémentaires du bloc au niveau de l'additionneur. Le basculement progressif est ainsi mis en oeuvre.

Dans un mode de réalisation, ledit basculement progressif peut mettre en oeuvre des fondus dont les coefficients de fondu correspondants sont appliqués aux signaux filtrés par les premières cellules élémentaires de filtrage et par les autres cellules élémentaires de filtrage, typiquement des fondus inverses, l'un en fermeture et l'autre en ouverture, au sein d'un même premier bloc filtrant.

Le fondu en ouverture et le fondu en fermeture sont également connus sous les termes anglo-saxons *"fade-in"* et *"fade-out",* désignant une augmentation progressive et une diminution progressive de l'amplitude d'un signal. Ainsi, en appliquant le fondu en même temps à toutes les premières cellules élémentaires de filtrage, on éteint progressivement le premier filtre ARMA (fondu en fermeture de ces cellules élémentaires) ou on l'active progressivement (fondu en ouverture), tout en conservant l'approche par cellule élémentaire permettant une initialisation rapide des variables internes.

De même, le filtrage résultant de la mise en cascade de cellules élémentaires de filtrage associées dans les blocs filtrants (correspondant à un autre filtre ARMA ou un filtre "identité" par exemple) est également activé ou éteint progressivement, de façon inverse au premier filtre ARMA.

En variante, le basculement peut être immédiat, par exemple par application de la "technique d'évanouissement" précitée. Le basculement progressif, type *"fade-in / fade-out"*, limite cependant l'apparition d'artefacts audibles, et permet ainsi de basculer plus rapidement d'un filtre ARMA ou RII à l'autre, à artefact "constant".

Selon une caractéristique particulière, les fondus appliqués aux signaux filtrés par la première cellule élémentaire de filtrage et par l'autre cellule élémentaire de filtrage d'un même premier bloc filtrant sont des fondus inverses, l'un en ouverture et l'autre en fermeture, dont les coefficients de fondu correspondants varient dans le temps.

Les coefficients de fondu représentent un coefficient de mixage entre les deux signaux, représentatif du mélange selon la fonction *"fade-in / fade-out".* Cette disposition montre que le changement de filtre ARMA regroupe un ensemble de basculements au niveau de chaque bloc filtrant. On veillera de préférence à procéder à un basculement simultané, et éventuellement avec un même coefficient de mixage, pour l'ensemble des blocs filtrants. Toutefois, d'autres mises en oeuvre peuvent être envisagées dans le cadre de la présente invention, telle que l'application de coefficients de fondu différents (dans la forme et/ou la durée) d'un bloc filtrant à l'autre, voire même dans un bloc filtrant donné, entre ladite première cellule élémentaire et la cellule élémentaire associée.

Selon une configuration de l'invention, au sein de chaque premier bloc filtrant, la dite autre cellule élémentaire de filtrage est mise en parallèle de ladite première cellule élémentaire de filtrage à laquelle est appliqué un coefficient de basculement, et la dite autre cellule élémentaire de filtrage met en oeuvre un filtre identité pondéré par un coefficient de basculement complémentaire. Cette configuration permet de mettre en oeuvre de façon simple un mécanisme de contrôle de la simple activation ou simple extinction dudit premier filtre ARMA. En effet dans ce cas, en l'absence d'activation de celui-ci (donc soit avant le basculement, soit après celui-ci), seules des cellules filtres identité sont mises en cascade, assurant l'obtention d'un filtre global identité, c'est-à-dire aucun filtrage modificateur.

Dans cette configuration, la première cellule élémentaire de filtrage et la cellule filtre "identité" en parallèle reçoivent le même signal numérique en entrée (celui de sortie d'un bloc filtrant précédent). Elles fournissent également un signal de sortie commun combiné à l'aide d'un coefficient de mixage (coefficients de fondu tels qu'évoqués précédemment par ailleurs) dont la composante affectée à la cellule filtre "identité" (le coefficient de basculement) est inverse ou complémentaire du coefficient (de fondu) affecté à la première cellule élémentaire de filtrage associée.

Cette complémentarité est à mettre en lien avec le coefficient de mixage évoqué qui vient préciser le degré de progressivité dans le basculement. Elle se rapporte aussi au fait que les contributions de la première cellule élémentaire de filtrage et de la cellule "identité" ne doivent, de préférence, pas introduire d'atténuation ou d'amplification inutile du signal numérique filtré. Dans ce cas, la somme des deux coefficients appliqués à la première cellule élémentaire et à la cellule filtre "identité" parallèle pourrait être égale à 100% (moyenne en amplitude), ou la somme de leurs carrés pourrait être égale à 100% (moyenne en énergie). Bien entendu, d'autres scénarii de complémentarité entre les coefficients appliqués peuvent être envisagés.

Dans un mode de réalisation particulier, deux filtres ARMA décomposés, chacun en blocs filtrants de cellules élémentaires décrits précédemment, peuvent être mis en série pour basculer de l'un à l'autre. Dans ce cas, ladite pluralité de premiers blocs filtrants est mise en série d'une pluralité de deuxièmes blocs filtrants en cascade comprenant, chacun, une deuxième cellule élémentaire de filtrage issue d'une factorisation d'un deuxième filtre ARMA mise en parallèle d'une cellule filtre identité et pondérée par un coefficient de basculement, l'ensemble des deuxièmes cellules élémentaires de filtrage de la pluralité de deuxièmes blocs filtrants factorisant le deuxième filtre ARMA, et

le procédé comprend, au niveau des deuxièmes blocs filtrants, un basculement progressif d'un filtrage par les deuxièmes cellules élémentaires inverse du basculement progressif de filtrage par les premières cellules élémentaires au niveau des premiers blocs filtrants, de sorte à contrôler un basculement progressif entre un filtrage par le premier filtre ARMA et un filtrage par le deuxième filtre ARMA.

Ainsi, la gestion d'un basculement entre deux filtres ARMA est gérée de façon modulaire, en mettant en série des blocs filtrants correspondants décomposant les filtres ARMA souhaités, et en les pilotant de façon inverse.

Selon une autre configuration de l'invention, les deux filtres RII décomposés en cellules élémentaires peuvent être instanciés en parallèle. Dans ce cas, au sein desdits premiers blocs filtrants, la dite autre cellule élémentaire de filtrage est mise en parallèle de ladite première cellule élémentaire de filtrage et comprend une deuxième cellule élémentaire de filtrage issue d'une factorisation d'un deuxième filtre ARMA.

Par cette mise en parallèle, les première et deuxième cellules élémentaires de filtrage d'un bloc filtrant reçoivent et filtrent le même signal numérique d'entrée du bloc filtrant (correspondant au signal de sortie du bloc filtrant amont), et leurs signaux filtrés peuvent alors être combinés en tenant compte du basculement de l'un à l'autre (c'est-à-dire en pratique en fonction d'un coefficient de mixage par exemple) pour générer le signal filtré de sortie du bloc filtrant considéré.

En particulier, si l'une des factorisations des premier et deuxième filtres ARMA comprend plus de cellules élémentaires de filtrage que l'autre, une cellule filtre de type filtre identité est associée à chaque cellule élémentaire de filtrage surnuméraire pour former un dit bloc filtrant. Cette disposition permet de traiter efficacement le cas de filtres ARMA ne présentant pas le même ordre (pour la partie MA ou AR par exemple).

Comme le basculement est progressif, il n'est pas rare qu'une nouvelle demande de changement de filtre ARMA arrive alors que le basculement n'est pas fini, c'est-à-dire alors que les deux filtrages au sein d'un bloc filtrant contribuent chacun en partie au signal de sortie de celui-ci.

Ainsi, selon un mode de réalisation de l'invention, en réponse à une deuxième demande de changement de filtrage inverse de la première demande (c'est-à-dire retourner au filtrage tel qu'il était avant le début dudit basculement) et reçue lors du basculement progressif, il peut être prévu d'inverser ledit basculement de filtrage depuis l'état de basculement correspondant à l'instant de réception de ladite deuxième demande de changement. Cette inversion peut être réalisée par interversion des coefficients de fondu appliqués, ou par interversion entre augmentation et diminution des coefficients de fondu appliqués, depuis leurs valeurs respectives à l'instant de la réception de la nouvelle demande.

Cette disposition permet de maintenir inchangées les mémoires internes des filtres et ainsi d'éviter des discontinuités dans le signal audio (générant des artefacts désagréables) tout en ne retardant pas le traitement de la nouvelle demande. Elle est particulièrement utile pour certaines applications audio dans lesquelles un même filtre est régulièrement désactivé et réactivé (par exemple, cas de chocs acoustiques de faible volume où la décision d'activation peut être instable).

Dans un autre mode de réalisation de l'invention, le procédé comprend, en outre, en réponse à une troisième demande de changement de filtre ARMA vers un nouveau filtre ARMA reçue lors dudit basculement progressif, une étape de basculement progressif, au niveau de chaque premier bloc filtrant, entre le filtrage de signal numérique par ledit premier bloc filtrant dans l'état correspondant à l'instant de réception de ladite troisième demande et un filtrage de signal numérique par une nouvelle cellule élémentaire de filtrage issue d'une factorisation dudit nouveau filtre ARMA.

La combinaison progressive type *"fade-in / fade-out"* peut ainsi être réalisée entre la sortie d'une cellule élémentaire du troisième filtre ARMA et la sortie d'un bloc filtrant dans l'état dans lequel il se trouvait lors de la réception de la nouvelle demande de changement de filtre ARMA. Il est ainsi aisé d'intégrer de façon modulaire et récursive un grand nombre de filtres ARMA au fur et à mesure qu'ils sont activés, alors même que la transition précédente (basculement précédent) n'est pas terminée.

Le filtrage ainsi obtenu est lissé malgré le nombre important de changement de filtres ARMA.

Selon un mode de réalisation de l'invention, les première et deuxième cellules élémentaires de filtrage sont des filtres du premier ou second ordre. L'ordre d'un filtre, et donc des cellules élémentaires de filtrage, est notamment le plus grand des degrés des polynômes numérateur et dénominateur constituant leur fonction de transfert. Du coup, les initialisations des variables internes à chaque cellule élémentaire sont de durées très inférieures aux durées des techniques classiques pour un filtre ARMA complet. Par conséquent, cette disposition garantit une durée de basculement brève entre les deux filtres ARMA.

En particulier, les première et deuxième cellules élémentaires de filtrage sont des filtres du premier ou second ordre à coefficients réels. Cette disposition permet d'avoir des opérations de factorisation, c'est-à-dire de décomposition du filtre ARMA en cellules élémentaires de filtrage, qui mettent en oeuvre des calculs peu complexes.

Selon une caractéristique particulière, les première et deuxième cellules élémentaires de filtrage sont des filtres du premier ordre résultant de la décomposition des premier et deuxième filtres ARMA en treillis. Le recours à des filtres du premier ordre assure un temps minimal d'initialisation des variables internes et donc du basculement entre filtres ARMA.

En variante, les première et deuxième cellules élémentaires de filtrage sont des filtres du second ordre. Cette disposition offre une complexité moindre (moins de cellules élémentaires à instancier) tout en conservant des temps d'initialisation très faibles.

Corrélativement, l'invention concerne un dispositif de filtrage d'un signal numérique à l'aide d'au moins un filtre ARMA, comprenant:

- une pluralité de premiers blocs filtrants mis en cascade, comprenant chacun une première cellule élémentaire de filtrage et une autre cellule élémentaire de filtrage associée, l'ensemble desdites premières cellules élémentaires de filtrage de la pluralité de premiers blocs filtrants factorisant un premier filtre ARMA;
- au moins un élément de contrôle pour commander, au niveau de chaque premier bloc filtrant, un changement de filtrage en réponse à une première demande de changement de filtrage vers ou depuis un filtrage par le premier filtre ARMA, et
- chaque dit premier bloc filtrant est configuré pour opérer le changement de filtrage par basculement progressif entre un filtrage de signal numérique par la première cellule élémentaire de filtrage et un filtrage de signal numérique par la dite autre cellule élémentaire de filtrage associée.

La mise en oeuvre logicielle, matérielle ou hybride de filtres numériques est connue en soi. Le dispositif selon l'invention peut ainsi être mis en oeuvre de façon logicielle, matérielle ou hybride.

Le dispositif selon l'invention présente des avantages similaires à ceux du procédé exposé ci-dessus, notamment celui de réduire la latence lors d'un changement de filtre ARMA.

De façon optionnelle, le dispositif peut comprendre des moyens se rapportant aux caractéristiques de procédé évoquées précédemment.

Dans un mode de réalisation, chaque dit premier bloc filtrant comprend un additionneur pour combiner au moins temporairement un signal filtré par la première cellule élémentaire de filtrage avec un signal filtré par la dite autre cellule élémentaire de filtrage associée, de sorte à générer un signal de sortie mixée de bloc filtrant pendant le basculement progressif.

Dans un autre mode de réalisation, l'au moins un élément de contrôle comprend des moyens d'atténuation progressive du signal filtré par la première cellule élémentaire de filtrage et du signal filtré par la dite autre cellule élémentaire de filtrage associée avant combinaison, selon respectivement deux coefficients complémentaires de fondu, l'un de fondu en fermeture et l'autre de fondu en ouverture.

Selon une configuration de l'invention, au sein de chaque premier bloc filtrant, la dite autre cellule élémentaire de filtrage est mise en parallèle de ladite première cellule élémentaire de filtrage à laquelle est appliqué un coefficient de basculement et la dite autre cellule élémentaire de filtrage met en oeuvre un filtre identité pondéré par un coefficient de basculement complémentaire.

En particulier, dans une mise en oeuvre "en série", ladite pluralité de premiers blocs filtrants est mise en série d'une pluralité de deuxième blocs filtrants en cascade comprenant, chacun, une deuxième cellule élémentaire de filtrage issue d'une factorisation d'un deuxième filtre ARMA mise en parallèle d'une cellule filtre identité et pondérée par un coefficient de basculement, l'ensemble desdites deuxièmes cellules élémentaires de filtrage de la pluralité de deuxièmes blocs filtrants factorisant le deuxième filtre ARMA, et

le dispositif comprend, au niveau des deuxièmes blocs filtrants, des éléments de contrôle d'un basculement progressif de filtrage par les deuxièmes cellules élémentaires inverse du basculement progressif de filtrage par les premières cellules élémentaires au niveau des premiers blocs filtrants, de sorte à contrôler un basculement progressif entre un filtrage par le premier filtre ARMA et un filtrage par le deuxième filtre ARMA.

Selon une configuration "parallèle", au sein desdits premiers blocs filtrants, la dite autre cellule élémentaire de filtrage est mise en parallèle de ladite première cellule élémentaire de filtrage et comprend une deuxième cellule élémentaire de filtrage issue d'une factorisation d'un deuxième filtre ARMA.

Notamment, si l'une des factorisations des premier et deuxième filtres ARMA comprend plus de cellules élémentaires de filtrage que l'autre, une cellule filtre de type filtre identité est associée à chaque cellule élémentaire de filtrage surnuméraire pour former un dit bloc filtrant.

L'invention concerne également un moyen de stockage d'informations comprenant des instructions pour un programme informatique adapté à mettre en oeuvre le procédé de filtrage conforme à l'invention lorsque ce programme est chargé et exécuté par un système informatique.

L'invention concerne également un programme d'ordinateur lisible par un microprocesseur, comprenant des instructions pour la mise en oeuvre du procédé de filtrage conforme à l'invention, lorsque ce programme est chargé et exécuté par le microprocesseur.

Les moyens de stockage d'information et programme d'ordinateur présentent des caractéristiques et avantages analogues aux procédés qu'ils mettent en oeuvre.

D'autres particularités et avantages de l'invention apparaîtront dans la description ci-après, illustrée par les dessins ci-joints, dans lesquels :

- la **figure 1** illustre schématiquement un premier exemple de mise en oeuvre de l'invention;
- les **figures 2, 2a** et **2b** représente des exemples de fonction de *fade out* mises en oeuvre dans le changement progressif de filtres RII selon l'invention;
- la **figure 3** illustre schématiquement un deuxième exemple de mise en oeuvre de l'invention;
- la **figure 4** illustre schématiquement un autre exemple de mise en oeuvre du dispositif de filtrage selon l'invention; et
- la **figure 5** montre une configuration matérielle particulière d'un dispositif ou système apte à une mise en oeuvre du procédé selon l'invention.

Considérons, pour la présente illustration, deux filtres numériques linéaires à réponse impulsionnelle infinie ou "filtres RII" ou "filtres récursifs", notés $h_1$ et $h_2$, présentant tous deux un même ordre pair, noté L, pour leurs parties MA et AR respectives.

L'invention s'applique bien entendu à d'autre cas de filtres ARMA et RII,

Par exemple, elle s'applique à des filtres non linéaires (notamment les filtres de Volterra), à des filtres RIF, et également au cas où les deux filtres RII $h_1$ et $h_2$ présentent des ordres non pairs et/ou différents, ou au cas où, pour un même filtre RII $h_1$ ou $h_2$, les parties MA et AR présentent également des ordres non pairs et/ou différents. L'homme de l'art sera à même d'ajuster les explications suivantes à ces divers cas envisagés en obtenant par exemple une cellule du premier ordre en complément de cellules du second ordre, ou en obtenant des cellules élémentaires de filtrage dont le dénominateur ou le numérateur est une constante alors que le numérateur ou le dénominateur associé est un polynôme de degré au moins égal à 1. Notamment la publication susvisée *"The Volterra and Wiener theories of nonlinear systems"* fournit des indications pour l'obtention d'une factorisation d'un système non linéaire en cellules élémentaires.

De façon connue en soi, les filtres RII linéaires $h_i$ (i=1 ou 2) sont définis par les transformées en z suivantes:

$$H_i(z) = \frac{B_i(z)}{A_i(z)} = G.\frac{\prod_{l=0}^{\frac{L}{2}-1}(1-\beta_{i,l}.z^{-1})(1-\overline{\beta_{i,l}}.z^{-1})}{\prod_{l=0}^{\frac{L}{2}-1}(1-\alpha_{i,l}.z^{-1})(1-\overline{\alpha_{i,l}}.z^{-1})},$$

où $H_i(z)$ est la transformée en z du filtre $h_i$, G est le gain du filtre $H_i$, et $\alpha_{i,l}$ et $\beta_{i,l}$ sont des coefficients complexes.

La fonction de transfert $H_i(z)$ peut également se factoriser en cellules du second ordre comme suit:

$$H_i(z) = \frac{B_i(z)}{A_i(z)} = \frac{\prod_{l=0}^{\frac{L}{2}-1}(b_{i,l,0}+b_{i,l,1}.z^{-1}+b_{i,l,2}.z^{-2})}{\prod_{l=0}^{\frac{L}{2}-1}(1-a_{i,l,1}.z^{-1}-a_{i,l,2}.z^{-2})} = \prod_{l=0}^{\frac{L}{2}-1}h_i^l(z),$$

où $a_{i,l}$, et $b_{i,l}$ sont des coefficients réels.

Ces formules montrent comment un filtre RII $h_i$ peut être factorisé en cellules du premier ordre et/ou en cellules $h_i^l$ (I = 0 ... L/2-1) du second ordre, c'est-à-dire que sa fonction de transfert est décomposée en un produit de cellules polynomiales du second degré. Le premier filtre RII $h_1$ est ainsi factorisé en une pluralité de premières cellules élémentaires de filtrage $h_1^l$ et le deuxième filtre RII $h_2$ est factorisé en une pluralité de deuxièmes cellules élémentaires de filtrage $h_2^l$.

On voit ici que la généralisation évoqué précédemment à tout filtre RII de dimensions quelconques est immédiate, sachant que tout filtre peut se factoriser comme un ratio de produits de cellules du premier et du second ordre à coefficients réels (décomposition en treillis, en cellules du second ordre).

Selon l'invention, on peut également utiliser toute autre décomposition avec des cellules d'ordres supérieurs (au second ordre) si nécessaire. Toutefois, on favorisera la décomposition en cellules du premier et du second ordre réelles car les calculs correspondants moins complexes contribuent à une meilleure optimisation de l'invention.

Notons x(n) le signal numérique audio à filtrer (X(z) sa transformée en z) et y(n) le signal filtré résultant (Y(z) sa transformée), n étant l'indice d'échantillon.

La présente invention vise la gestion du filtrage lors d'un changement de filtre RII: par exemple l'activation d'un filtre RII en l'absence préalable de filtrage; l'extinction d'un filtre RII au profit d'une absence de filtrage; le passage d'un filtre RII à un nouveau filtre RII (cas décrit par la suite) ou à une version modifiée du même filtre courant.

Un tel changement peut être demandé par un opérateur au travers d'une interface utilisateur, ou par un autre système (par exemple un logiciel de réduction de bruits). Dans ces divers cas, une commande de changement de filtre RII est reçue.

Prenons l'exemple d'une désactivation d'un filtre RII $h_1$ courant pour l'activation d'un deuxième filtre RII $h_2$. En d'autres termes, il s'agit du changement de filtre $h_1$ en $h_2$ à l'instant T:

$$\text{théoriquement } y(n) = \begin{cases} x(n) * h_1, \forall n < T \\ x(n) * h_2, \forall n \geq T \end{cases}.$$

Les autres cas évoqués découlent sans difficulté de cet exemple: par exemple en prenant des filtres "identité" (H(z)=z) pour $h_1$ ou $h_2$ pour illustrer respectivement la simple activation de $h_2$ ou la simple extinction de $h_1$.

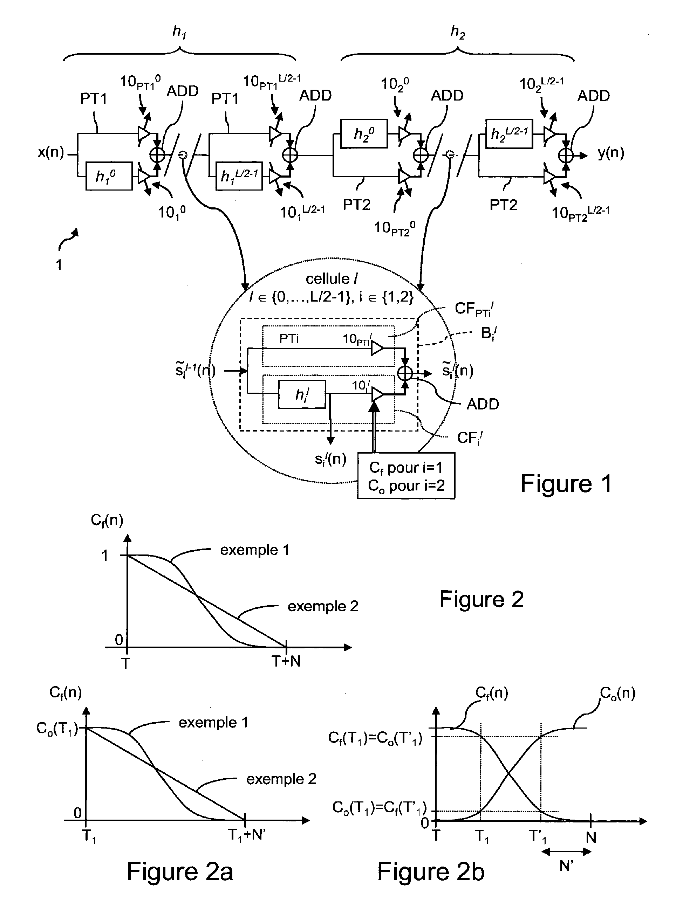

La **figure 1** illustre schématiquement un premier exemple de mise en oeuvre de l'invention pour gérer ce basculement à l'instant T du filtre $h_1$ au filtre $h_2$. Les cellules élémentaires de filtrage montrées sur cette figure, ainsi que les éléments de contrôle associés peuvent être mis aisément en oeuvre au travers de logiciels et/ou d'éléments matériels.

Ce premier exemple correspond à un dispositif de filtrage 1 mettant en oeuvre "en série" les filtres $h_1$ et $h_2$.

Comme cela ressort de la figure, chaque filtre $h_i$ constitue un "bloc" qui est facilement manipulable pour être connecté en série à un autre "bloc" représentant un autre filtre RII. Ainsi, il est aisé de "connecter" en série ou substituer n'importe quel filtre à un autre filtre, aux fins de mise en oeuvre de la présente invention.

Dans cette configuration, chaque filtre $h_i$ est constitué de la mise en cascade des cellules élémentaires de filtrage $h_i^l$ qui le décomposent. $l$ est un indice des cellules élémentaires de filtrage qui dépend de la décomposition effectuée. Par exemple, pour une décomposition en cellules élémentaires du premier ordre uniquement, on obtient L cellules et l'indice $l$ varie de 0 à L-1. De même, pour une décomposition en cellules élémentaires du second ordre uniquement, on obtient U2 cellules et l'indice $l$ varie de 0 à L/2-1.

A chaque cellule élémentaire de filtrage $h_i^l$ est associé, en sortie, un élément de contrôle $10_i^l$, par exemple un module potentiomètre permettant d'appliquer un facteur d'atténuation ou "coefficient de fondu" au signal filtré par $h_i^l$. L'ensemble de ces deux éléments est nommé cellule filtre $CF_i^l$. A noter que dans une mise en oeuvre logicielle, cet élément de contrôle peut consister en un coefficient de fondu appliqué directement au signal sortant de la cellule élémentaire de filtrage correspondante.

Comme il ressort de la suite des explications, une cellule filtre $CF_i^l$ comprend une cellule élémentaire de filtrage et un élément de contrôle associé, permettant de filtrer un signal d'entrée. Selon différentes réalisations, l'élément de contrôle peut être placé après la cellule élémentaire ou avant la cellule élémentaire.

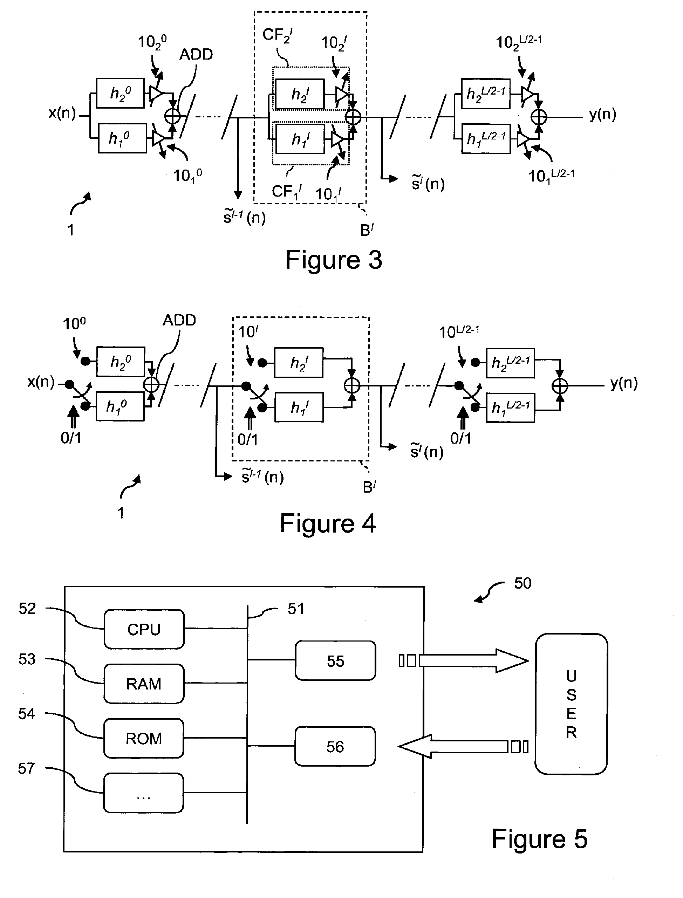

Dans le cas d'un placement après la cellule élémentaire (cas des **figures 1** et **3** par exemple), cet élément de contrôle ne peut être un simple basculement instantané type interrupteur (ou *switch*), mais offre une transition progressive (type fondu notamment).

Dans le cas d'un placement avant la cellule élémentaire (cas de la **figure 4** par exemple), cet élément de contrôle peut s'avérer être un simple interrupteur. En effet, le temps de réponse impulsionnelle des cellules élémentaires (ces cellules ont une "mémoire") garantit une contribution non nulle de ces cellules "débranchées" au niveau d'additionneurs correspondants, et donc un basculement progressif selon l'invention au niveau de chaque bloc filtrant. Avec un élément de contrôle de type progressif (coefficient de fondu par exemple), cette contribution due à la "mémoire" se trouve en outre modifiée par le coefficient de fondu appliqué par l'élément de contrôle.

Dans l'exemple de la **figure 1,** l'élément de contrôle permet de mettre en oeuvre une fonction *fade in/fade out* lors du basculement entre les deux filtres $h_1$ et $h_2$.

Les éléments de contrôle $10_1^l$ contrôlant les premières cellules élémentaires de filtrage $h_1^l$ sont de préférence identiques, appliquant simultanément un même coefficient $C_f$ de fondu en fermeture lors du basculement vers le filtre RII $h_2$ (par exemple progressivement depuis 100% jusqu'à 0%).

Les éléments de contrôle $10_2^l$ contrôlant les deuxièmes cellules élémentaires de filtrage $h_2^l$ sont de préférence identiques, appliquant simultanément un même coefficient $C_o$ de fondu en ouverture lors du même basculement (par exemple progressivement depuis 0% jusqu'à 100%). Notamment, le coefficient $C_o$ de fondu en ouverture peut être complémentaire du coefficient $C_f$ de fondu en fermeture, c'est-à-dire par exemple $C_o + C_f = 100\%$. A noter que le ratio $C_o / C_f$ est dénoté coefficient de mixage.

Par ailleurs, chaque cellule filtre $CF_i^l$ (c'est-à-dire une cellule élémentaire de filtrage $h_i^l$ et son élément de contrôle $10_i^l$ associé) est mise en parallèle d'une cellule filtre "identité" $CF_{PTi}^l$ composée d'une cellule élémentaire de filtrage de type "identité" PTi (c'est-à-dire laissant tout passer, représenté symboliquement par un trait sur la figure) et d'un élément de contrôle associé $10_{PTi}^l$ du même type que les éléments de contrôle $10_i^l$. Cette mise en parallèle consiste à appliquer un même signal d'entrée aux deux cellules élémentaires et à obtenir un signal de sortie sommant les signaux de sortie respectifs de chaque cellule filtre $CF_i^l$ et $CF_{PTi}^l$.

Les deux cellules filtres $CF_i^l$, $CF_{PTi}^l$ reçoivent donc le même signal d'entrée $\tilde{s}_i^{l-1}(n)$ et génèrent respectivement un signal filtré de sortie vers un additionneur ADD (ou mixeur). Ce dernier additionne les deux signaux filtrés obtenus de sorte à générer un signal filtré de sortie de bloc. Lors du basculement progressif, ce signal de sortie de bloc mixe ainsi les deux signaux filtrés, l'intensité de la contribution de chaque cellule élémentaire de filtrage $h_i^l$, PTi étant fonction du coefficient de fondu appliqué par l'élément de contrôle associé $10_i^l$, $10_{PTi}^l$.

On appelle ainsi "bloc filtrant" $B_i^l$ l'ensemble constitué des deux cellules filtres $CF_i^l$, $CF_{PTi}^l$ et de l'additionneur ADD. Un bloc filtrant reçoit donc un signal d'entrée à filtrer et génère un signal filtré de sortie qui est le signal d'entrée filtré par l'une des deux cellules élémentaires de filtrage $h_i^l$ ou PTi en période de fonctionnement stabilisé (état permanent) ou qui est, pendant le basculement progressif (état transitoire), une combinaison (un mixage) du signal d'entrée filtré respectivement par chacune des deux cellules élémentaires de filtrage. Selon le positionnement de l'élément de contrôle dans les cellules filtres, le degré de contribution du filtrage de chacune des cellules élémentaires est fonction des coefficients de basculement appliqués et/ou de la "mémoire" (réponse impulsionnelle) de ces cellules élémentaires.

En détail, l'élément de contrôle $10_{PTi}^l$ est complémentaire de l'élément de contrôle 101 : les éléments de contrôle $10_{PT1}^l$ mettent en oeuvre le coefficient de fondu en ouverture $C_o$, alors que les éléments de contrôle $10_{PT2}^l$ mettent en oeuvre le coefficient de fondu en fermeture $C_f$. En d'autres termes, chaque branche PT1 se comporte, vis-à-vis du coefficient de fondu, comme une cellule filtre $CF_2^l$ du deuxième filtre RII (vice et versa pour PT2 et les cellules filtres $CF_1^l$).

Dans le cas d'une décomposition des filtres RII en cellules élémentaires du second ordre, notons $s_i^l(n)$ *avec* $\left(i \in \{1;2\}, l \in \left\{0, ..., \dfrac{L}{2} - 1\right\}\right)$ la sortie (signal filtré) de chaque cellule élémentaire de filtrage $h_i^l$, et $\tilde{s}_i^l(n)$ la sortie du bloc filtrant $B_i^l$, c'est-à-dire le résultat du mixage en sortie du signal passant par la cellule filtre $CF_i^l$ avec le signal passant par la cellule filtre $CF_{PTi}^l$ ("identité") en parallèle.

Ces sorties s'écrivent alors de la façon suivante pour le filtre $h_1$ :

$$s_1^l(n) = \sum_{k=0}^{2} b_{1,l,k} . \tilde{s}_1^{l-1}(n-k) + \sum_{k=1}^{2} a_{1,l,k} . s_1^l(n-k)$$

$$\tilde{s}_1^l(n) = \begin{cases} s_1^l(n) = \tilde{s}_1^{l-1}(n) * h_1^l & n < T \\ C_f(n-T).s_1^l + (1 - C_f(n-T)).\tilde{s}_1^{l-1}(n) & T \le n < T + N \\ \tilde{s}_1^{l-1}(n) & n \ge T + N \end{cases}$$

avec la convention $\tilde{s}_1^{-1}(n) = x(n)$ (signal d'entrée) et où le coefficient de fondu $C_f(n)$ est une fonction de *fade out* généralement décroissante et monotone (exemples représentés sur la figure 2) et $C_o = 1 - C_f$ dans cet exemple.

N désigne la durée de basculement entre les deux filtres RII. Elle peut être déterminée de façon empirique ou par expérimentation et est choisie bien inférieure aux durées d'initialisation des techniques de l'art antérieur. N peut être choisi égal à une valeur LONG telle que définie précédemment mais calculée pour une desdites cellules élémentaires de filtrage, par exemple la plus grande longueur couvrant 80% de l'énergie d'une réponse impulsionnelle (infinie) parmi l'ensemble des cellules élémentaires de filtrage

De façon correspondante, les sorties concernant le filtre $h_2$ s'écrivent de la façon suivante, pour $C_o=1-C_f$:

$$s_2^l(n) = \sum_{k=0}^{2} b_{2,l,k} . \tilde{s}_2^{l-1}(n-k) + \sum_{k=1}^{2} a_{2,l,k} . s_2^l(n-k)$$

$$\tilde{s}_2^l(n) = \begin{cases} \tilde{s}_2^{l-1}(n) & n < T \\ \left(1 - C_f(n-T)\right)s_2^l + C_f(n-T).\tilde{s}_2^{l-1}(n) & T \le n < T + N \\ s_2^l(n) = \tilde{s}_2^{l-1}(n) * h_2^l & n \ge T + N \end{cases}$$

avec la convention $\tilde{s}_2^{-1}(n) = \tilde{s}_1^{L/2-1}(n)$ de signal d'entrée.

A noter que si dans cet exemple on applique, à $h_2$, le même coefficient de fondu $C_f$ (via $C_o = 1 - C_f$) que pour le filtre $h_1$, celui-ci peut être remplacé par un coefficient de fondu différent $C_f'$ correspondant à une fonction similaire à $C_f$ mais dont le support temporel et la forme peuvent être différentes.

En outre, l'invention s'applique également si le deuxième filtre RII $h_2$ est placé avant le premier filtre $h_1$ (contrairement à la figure).

En régime permanent avant l'instant T, le signal d'entrée x(n) est filtré uniquement par le filtre RII $h_1$:

$$y(n) = \tilde{s}_2^{L/2-1}(n) = \tilde{s}_1^{L/2-1}(n) = \tilde{s}_1^{L/2-2}(n) * h_1^{L/2-1} = \tilde{s}_1^{-1}(n) * h_1^0 * \ldots * h_1^{L/2-1} = x(n) * h_1.$$

Cela correspond à une configuration du dispositif 1 dans laquelle le coefficient $C_f$=100% et le coefficient $C_o$=0%. En effet, le signal x(n) est alors successivement filtré par chacune des premières cellules élémentaires de filtrage $h_1^l$ puis traverse la deuxième partie du dispositif par les branches "identité" PT2. Les contributions des branches PT1 et $h_2^l$ ne sont pas prises en compte en raison du coefficient $C_o$=0%.

A l'instant T, le basculement entre les deux filtres RII $h_1$ et $h_2$ débute, pour une durée N.

Dans le présent mode de réalisation de l'invention, le principe est alors de progressivement éteindre le premier filtre RII $h_1$ en réduisant progressivement le coefficient $C_f$ (et en augmentant $C_o$ de façon complémentaire), de sorte que progressivement le signal d'entrée passe par les branches "identité" PT1. Cette réduction progressive est réalisée par un *fade out*.

De même, le deuxième filtre RII $h_2$ est progressivement allumé en augmentant $C_o$ de façon complémentaire à $C_f$ (il s'agit donc par exemple d'un *fade in*), diminuant progressivement le signal passant par les branches PT2.

En d'autres termes, durant les N échantillons du basculement, le signal numérique est filtré par les deux filtres RII $h_1$ et $h_2$, leurs contributions respectives variant selon $C_f$.

Pour chaque paire ($h_1^l$, $h_2^l$), $\forall l$, le basculement au niveau des cellules élémentaires consiste à progressivement diminuer la contribution de la cellule élémentaire de filtrage provenant du premier filtre RII $h_1$, au profit de la contribution de l'autre cellule élémentaire de la paire (provenant du filtre RII $h_2$).

Dans chaque bloc filtrant $B_i^l$, ce basculement consiste à progressivement diminuer la contribution des premières cellules élémentaires de filtrage $h_1^l$ (resp. des cellules filtres "identité" $CF_{PT2}^l$ ) au profit de la contribution des cellules filtres "identité" associées $CF_{PT1}^l$ (resp. des deuxièmes cellules élémentaires de filtrage $h_2^l$ ).

Selon l'invention, ce contrôle du basculement est réalisé au niveau de chaque bloc filtrant (et de chaque cellule élémentaire de filtrage) à l'aide d'un moyen approprié pilotant les coefficients $C_o$ et $C_f$ appliqués par les éléments de contrôle $10_i^l$ et $10_{PTi}^l$ . Ainsi durant ces N échantillons, on calcule, comme signal filtré de sortie pour chaque bloc filtrant $sB_i^l$ , par exemple le barycentre du signal de sortie du bloc précédant (via la branche PTi) avec le résultat de ce signal filtré par la cellule élémentaire de filtrage $h_i^l$ , respectivement affectés d'un coefficient de fondu ($C_f$ pour les cellules élémentaires de $h_1$ et $C_o$=f($C_f$) par exemple $C_o$=1-$C_f$ pour les cellules élémentaires de $h_2$) et du coefficient complémentaire. Ces coefficients favorisent les signaux filtrés par $h_1$ au début du basculement ($C_f$ proche de 1), et favorisent les signaux filtrés par $h_2$ en fin de basculement ($C_f$ proche de 0).

En fin de basculement (n≥T+N), le signal numérique x(n) est uniquement filtré par le filtre RII $h_2$. En effet, $C_f$=0 et donc:

$$y(n) = \tilde{s}_2^{L/2-1}(n) = s_2^{L/2-1}(n) = \tilde{s}_2^{L/2-2}(n) * h_2^{L/2-1} = \tilde{s}_2^{-1}(n) * h_2^0 * \ldots * h_2^{L/2-1}$$
$$= \tilde{s}_1^{L/2-1}(n) * h_2 = \tilde{s}_1^{-1}(n) * h_2 = x(n) * h_2$$

Le premier filtre RII $h_1$ n'est alors plus utilisé. Il peut être désactivé de telle sorte que seul le deuxième filtre RII $h_2$ est conservé pour la poursuite du traitement. Un nouveau basculement de ce dernier vers un autre filtre peut alors être effectuée en appliquant les enseignements de l'invention avec, à nouveau, en série la décomposition de cet autre filtre (dans ce cas le coefficient $C_o$ appliqué aux cellules élémentaires $h_2^l$ devient un coefficient de fondu en fermeture $C_f$).

Il n'est pas rare que, pendant le basculement d'un filtre RII à un autre, une nouvelle demande de changement de filtre RII arrive alors que le basculement n'est pas fini. La nouvelle demande arrive par exemple à l'instant $T_1$, avec $T<T_1<T+N$.

Il peut s'agir d'une demande visant à rebasculer vers le premier filtre RII $h_1$.

Dans ce cas, il peut être prévu qu'en réponse, le basculement de filtrage soit inversé depuis l'état de basculement au moment où cette nouvelle demande est reçue.

Par exemple, si à cet instant $T_1$, on applique les coefficients $C_f(T_1)$ au filtre $h_1$ et $C_o(T_1)$ au filtre $h_2$, l'inversion de basculement consiste alors à appliquer un nouveau coefficient de fondu en fermeture $C_f$ au filtre $h_2$ et un nouveau coefficient de fondu en ouverture $C_o$ au filtre $h_1$, prenant sensiblement la forme de la **figure 2** (sur une durée N' qui peut être égale ou différente de N), mais avec des valeurs à l'origine égales, respectivement, à $C_o(T_1)$ et $C_f(T_1)$ (**figure 2a**).

Reprendre ces valeurs à l'origine garantit l'absence de discontinuité dans le signal filtré, et donc d'artefacts audibles.

Dans une variante réduisant le temps de retour à l'état de filtrage par $h_1$, on peut reparcourir en sens inverse le profil des coefficients de fondu alors appliqués. Dans le cas par exemple d'un profil symétrique, cela peut correspondre à se placer instantanément à l'instant $T'_1$ et à appliquer la fin du profil de coefficient de la **figure 2** tout en inversant $C_f$ (alors appliqué à $10_2^l$ et $10_{PT1}^l$) et $C_o$ (alors appliqué à $10_1^l$ et $10_{PT2}^l$), avec $C_f(T'_1)=C_o(T_1)$ et $C_o(T'_1)=C_f(T_1)$ pour éviter toute discontinuité (**figure 2b**). Notamment avec $C_o=1-C_f$, $T'_1=N-(T_1-T)$, et la durée de transition pour retourner vers un filtrage par $h_1$ est $N'=T_1-T$.

Il peut également s'agir d'une demande visant à choisir un nouveau (troisième) filtre RII $h_3$. Une décomposition de celui-ci similaire à celles menées pour les filtres $h_1$ et $h_2$ est réalisée, pour obtenir des troisièmes cellules élémentaires de filtrage $h_3^l$ : $H_3(z) = \prod_{l=0}^{\frac{L}{2}-1} h_3^l(z)$ .

Dans ce cas, il peut être prévu qu'en réponse à la nouvelle demande, un nouveau basculement de filtrage soit réalisé depuis l'état de basculement au moment où cette nouvelle demande est reçue. Pour cela, on fige l'état de mixage de l'instant $T_1$ (c'est-à-dire les coefficients $C_f(T_1)$ et $C_o(T_1)$) et on considère l'ensemble des premier et deuxième filtres RII $h_1$ et $h_2$ comme un filtre unique (noté $h_{12}$) ayant cet état figé, en série duquel on place le nouveau filtre $h_3$ (au sein par exemple de blocs filtrants mis en série des blocs filtrants composant $h_{12}$).

On applique alors les enseignements précédents aux filtres $h_{12}$ (filtre de départ) et $h_3$ (filtre d'arrivée), notamment la présence de cellules filtres "identité" associées en parallèle de chaque cellule élémentaire de $h_{12}$ et $h_3$, ainsi que de nouveaux coefficients de fondu en fermeture $C_f'$ (pour $h_{12}$) et en ouverture $C_o'$ (égal à 1- $C_f'$, pour $h_3$).

A noter que pour simplifier la mise en oeuvre, le coefficient $C_o'$ est appliqué à chaque cellule élémentaire de filtrage $h_3^l$ (au travers d'éléments de contrôle $10_3^l$ ) et on applique aux éléments de contrôle $10_i^l$ déjà existants pour les filtres $h_1$ et $h_2$, le coefficient $C_f'$ aux valeurs figées $C_f(T_1)$ et $C_o(T_1)$.

La **figure 3** illustre schématiquement un deuxième exemple de mise en oeuvre de l'invention pour gérer ce basculement à l'instant T du filtre $h_1$ au filtre $h_2$. Les cellules élémentaires de filtrage montrées sur cette figure, ainsi que les éléments de contrôle associés peuvent être mis aisément en oeuvre au travers de logiciels et/ou d'éléments matériels.

Ce deuxième exemple correspond à un dispositif de filtrage 1 dans lequel les filtres $h_1$ et $h_2$ sont directement instanciés "en parallèle". Chaque cellule élémentaire de filtrage $h_1^l$ du premier filtre RII $h_1$ est ainsi associée à une cellule élémentaire de filtrage $h_2^l$ du deuxième filtre RII $h_2$ au sein de blocs filtrants $B^l$. De la sorte on évite la mise en oeuvre des cellules élémentaires "identité" PTi.

Chaque paire $\left(h_1^l, h_2^l\right)$ accompagnée des éléments de contrôles respectifs présente les mêmes propriétés que la paire de blocs filtrant $\left(B_1^l, B_2^l\right)$ de la **figure 1.** De ce fait, le basculement entre les deux filtres RII est réalisé de la même façon.

Dans cette configuration, L/2 paires, correspondantes à L/2 blocs filtrants $B^l$, sont mises en cascade.

La sortie $\tilde{s}^l(n)$ d'un bloc filtrant $B^l$ s'écrit comme suit, pour $C_o$=1-$C_f$:

$$\tilde{s}^l(n) = \begin{cases} s_1^l(n) & n < T \\ C_f(n-T).s_1^l + (1 - C_f(n-T)).s_2^l(n) & T \le n < T + N \\ s_2^l(n) & n \ge T + N \end{cases}$$

avec $s_i^l(n) = \sum_{k=0}^{2} b_{i,l,k}.\tilde{s}^{l-1}(n-k) + \sum_{k=1}^{2} a_{i,l,k}.s^l(n-k)$ au niveau de chaque cellule élémentaire de filtrage $h_i^l$ et la convention $\tilde{s}^{-1}(n) = x(n)$.

Les enseignements fournis précédemment en lien avec le premier exemple sont également applicables à ce deuxième exemple de dispositif de filtrage 1. C'est en particulier le cas pour la gestion d'une nouvelle demande de changement de filtre RII, pour la forme des fonctions $C_f$ et $C_o$, ou encore l'ordre des cellules élémentaires de filtrage.

A noter que dans le cas où les deux filtres RII $h_1$ et $h_2$ ont des parties AR et/ou MA d'ordres différents, le nombre de cellules élémentaires de filtrage peut être différent entre eux. Dans ce cas, on crée une ou plusieurs cellules élémentaires de type "identité" (PTi) que l'on associe, en parallèle, à chaque cellule élémentaire de filtrage surnuméraire du filtre RII présentant un plus grand nombre de cellules élémentaires $h_i^l$, pour former un bloc filtrant $B^l$. Ainsi, chaque cellule élémentaire des deux filtres RII fait partie d'un bloc filtrant.

La **figure 4** illustre schématiquement un exemple dégradé de mise en oeuvre du dispositif de filtrage selon l'invention.

Dans cet exemple, les éléments de contrôle $10_i^l$ et $10_{PTi}^l$ sont positionnés, au sein des cellules filtres, avant les cellules élémentaires de filtrage $h_i^l$ et PTi. La **figure 4** correspond au cas particulier où ces éléments de contrôle mettent en oeuvre une transition instantanée ($C_f(n<T)$=1; $C_f(n\ge T)$=0), représentés ici par un simple interrupteur $10^l$.

La progressivité du basculement résulte, dans ce cas, de la durée de réponse impulsionnelle des cellules élémentaires de filtrage, selon laquelle ces dernières continuent de générer un signal de sortie (signal d'extinction) même en l'absence de signal d'entrée. En effet, l'additionneur ADD combine alors ce signal d'extinction avec le signal filtré par l'autre cellule élémentaire "active", assurant de la sorte un basculement progressif.

On notera toutefois que la durée du basculement progressif est moins bien contrôlée ici que dans le cas des **figures 1** et **3,** où le profil du coefficient $C_f$ contrôle directement la durée N de basculement.

De retour à la **figure 4,** les éléments de contrôle $10_i^l$ sont de simples commutateurs ou interrupteurs ne permettant pas d'appliquer un basculement progressif. Ils permettent cependant d'obtenir des durées d'initialisation des variables internes qui sont considérables réduites du fait de l'utilisation des cellules élémentaires de filtrage $h_i^l$ selon l'invention au niveau desquelles le basculement est commandé (commande 0/1 représentée sur la figure pour commander simultanément l'ensemble des interrupteurs $10^l$ ).

Ce mode de réalisation dégradé peut se décliner aussi bien en version "série" de la **figure 1** qu'en version "parallèle" de la **figure 3.**

L'invention telle que décrite ci-dessus permet donc de réduire la latence dans le changement de filtres RII, de manière d'autant plus importante que ces filtres RII sont décomposées en cellules élémentaires de filtrage présentant des ordres faibles.

Quelques tests ont montré une efficacité notable de l'invention au regard des techniques connues. Par exemple en appliquant l'invention pour contrôler le basculement entre des filtres RII d'ordre 4, factorisés en deux cellules élémentaires d'ordre 2, les inventeurs ont obtenu une réduction de moitié du temps de basculement par rapport à la méthode hybride rapportée précédemment, à énergie constante d'artefact (clic audio).

La présente invention présente diverses applications dans le domaine du traitement de signaux numériques, et notamment de signaux audio, car l'utilisation de filtres RII variant dans le temps est très répandue.

A titre illustratif, c'est le cas des codeurs à prédiction linéaire (LPC - codeur de parole). Dans ce cas, le changement de filtre LPC d'une trame à l'autre est généralement fait par interpolation des coefficients. La mise en oeuvre de la présente invention permet alors d'améliorer la stabilité du filtrage pendant le basculement, en ayant une latence et une complexité faibles.

C'est aussi le cas de modules suppresseurs de chocs acoustiques. Tout terminal téléphonique a vocation à intégrer des limiteurs sur le signal haut-parleur dont la tâche est de protéger l'utilisateur de potentiels chocs acoustiques (signaux forts, Larsen, etc.). Par exemple, on trouve ces limiteurs dans des boîtiers autonomes pour l'usage des téléconseillers, dans les clients VoIP, dans les terminaux mobile.

Dans le cas de Larsen, le contenu fréquentiel varie généralement rapidement dans le temps. Si l'on suppose connues les fréquences qui composent le Larsen au cours du temps, la mise en oeuvre de l'invention permet d'adapter quasi instantanément les filtres RII utilisés à ces fréquences et permet ainsi de filtrer l'effet Larsen.

Enfin, c'est également le cas de systèmes de réduction de bruit. De tels systèmes sont mis en oeuvre dans tout terminal doté d'une prise de son, notamment de type mains-libres.

Dans ce cas, la mise en oeuvre de filtres de réduction de bruit fait appel à des filtres qui varient dans le temps pour s'adapter au contenu spectral de la parole et/ou du bruit. L'application des enseignements de l'invention à ces systèmes permet notamment d'améliorer ceux-ci eu égard à la latence.

La **figure 5** montre schématiquement un dispositif ou système 50 pour la mise en oeuvre de l'invention, notamment l'équipement doté des filtres RII et sur lequel est réalisé le basculement de filtre.

Le système 50 comprend un bus de communication 51 auquel sont reliés une unité centrale de traitement ou "microprocesseur" 52, une mémoire vive 53, une mémoire morte 54, un dispositif d'affichage 55 pour afficher des interfaces utilisateur, un dispositif de pointage 56 et éventuellement d'autres périphériques 57 (interface de communication, lecteur de disquette ou disques, etc.).

La mémoire morte 54 comprend les programmes dont l'exécution permet la mise en oeuvre du procédé selon l'invention, ainsi que par exemple des définitions logicielles de filtres RII, éventuellement déjà décomposés en cellules élémentaires de filtrage.

Lors de l'exécution de programmes, le code exécutable de ces programmes est chargé en mémoire vive 53, type RAM, et exécuté par le microprocesseur 52. Cette exécution permet l'instanciation des filtres RII et le contrôle de leur activation et de leur extinction, c'est-à-dire également du basculement d'un filtre RII à l'autre, comme représentés sur les **figures 1, 3** et **4** par exemple.

Le dispositif d'affichage 55, tel qu'un écran permet l'affichage d'interfaces graphiques utilisateurs permettant par exemple à un utilisateur de générer des commandes d'activation, extinction ou basculement de filtre RII.

Le dispositif de pointage 56 peut être intégré au dispositif d'affichage, notamment lorsqu'il s'agit d'un écran tactile, ou déporté, par exemple une souris, un *touchpad* ou encore une tablette graphique, pour permettre à l'utilisateur d'émettre ces commandes.

Le dispositif décrit ici et, particulièrement, l'unité centrale 52, sont susceptibles de mettre en oeuvre tout ou partie des traitements décrits en lien avec les **figures 1** à **4,** pour mettre en oeuvre les procédés objets de la présente invention et constituer les dispositifs et systèmes objets de la présente invention.

Les exemples qui précèdent ne sont que des modes de réalisation de l'invention qui ne s'y limite pas.

Par exemple, l'invention peut mettre en oeuvre uniquement le "bloc" $h_1$ de la **figure 1** (partie de gauche), correspondant ainsi au cas de la **figure 3** dans lequel le filtre $h_2$ est un filtre identité (les deuxièmes cellules élémentaires de filtrage sont alors également des cellules "identité"). Le basculement selon l'invention permet alors d'éteindre le filtre $h_1$ au profit d'une absence de filtrage, et cela sans artefact ou en les réduisant de manière significative.

De façon similaire, en mettant en oeuvre uniquement le "bloc" $h_2$ de la **figure 1** (partie de droite), le basculement selon l'invention permet d'activer le filtre $h_2$ alors qu'initialement aucun filtrage du signal numérique n'était réalisé, et cela sans artefact ou en les réduisant de manière significative.

**Revendications**

1. Procédé de filtrage d'un signal numérique (x) à l'aide d'au moins un filtre ARMA ($h_1$, $h_2$), comprenant une étape de réception d'une première demande de changement de filtrage vers ou depuis un filtrage par un premier filtre ARMA ($h_1$), **caractérisé en ce qu'**il comprend, en réponse à ladite première demande, une étape de basculement progressif, au niveau de chacun d'une pluralité de premiers blocs filtrants $(B_i^l, B^l)$ mis en cascade, entre un filtrage de signal numérique $(\tilde{s}_i^{l-1}(n))$ par une première cellule élémentaire de filtrage $(h_i^l)$ issue d'une factorisation du premier

filtre ($h_1$) et un filtrage de signal numérique ($\tilde{s}_i^{l-1}(n)$) par une autre cellule élémentaire de filtrage (PT1, $h_2^l$) associée, et

dans lequel l'ensemble desdites premières cellules élémentaires de filtrage ($h_1^l$) de la pluralité de premiers blocs filtrants ($B_1^l, B^l$) factorise ledit premier filtre ARMA ($h_1$).

2. Procédé selon la revendication 1, dans lequel le basculement progressif au niveau d'un premier bloc filtrant comprend la combinaison d'un signal filtré par la première cellule élémentaire de filtrage ; ($h_1^l$) avec un signal filtré par l'autre cellule élémentaire de filtrage (PT1, $h_2^l$) associée, de sorte à obtenir un signal de sortie mixée ($\tilde{s}_i^{l-1}(n)$) de bloc filtrant pendant le basculement progressif.

3. Procédé selon la revendication 2, dans lequel ledit basculement progressif met en oeuvre des fondus dont les coefficients de fondu correspondants ($C_f$, $C_0$) sont appliqués aux signaux filtrés par les premières cellules élémentaires de filtrage ($h_1^l$) et par les autres cellules élémentaires de filtrage (PT1, $h_2^l$).

4. Procédé selon la revendication 2, dans lequel au sein de chaque premier bloc filtrant ($B_1^l$), la dite autre cellule élémentaire de filtrage (PT1) est mise en parallèle de ladite première cellule élémentaire de filtrage ($h_1^l$) à laquelle est appliqué un coefficient de basculement, 25 et la dite autre cellule élémentaire de filtrage (PT1) met en oeuvre un filtre identité (PT1) pondéré par un coefficient de basculement complémentaire ($10^l_{PTI}$, $C_f$, $C_0$).

5. Procédé selon la revendication 4, dans lequel ladite pluralité de premiers blocs filtrants ($B_1^l$) est mise en série d'une pluralité de deuxièmes blocs filtrants ($B_2^l$) en cascade comprenant, chacun, une deuxième cellule élémentaire de filtrage ($h_2^l$) issue d'une factorisation d'un deuxième filtre ARMA ($h_2$) mise en parallèle d'une cellule filtre identité (PT2) et pondérée par un coefficient de basculement, l'ensemble desdites deuxièmes cellules élémentaires de filtrage ($h_2^l$) de la pluralité de deuxièmes blocs filtrants factorisant le deuxième filtre ARMA ($h_2$), et

le procédé comprend, au niveau des deuxièmes blocs filtrants ($B_2^l$), un basculement progressif d'un filtrage par les deuxièmes cellules élémentaires inverse du basculement progressif de filtrage par les premières cellules élémentaires au niveau des premiers blocs filtrants ($B_1^l$), de sorte à contrôler un basculement progressif entre un filtrage par le premier filtre ARMA ($h_1$) et un filtrage par le deuxième filtre ARMA ($h_2$).

6. Procédé selon la revendication 2, dans lequel au sein desdits premiers blocs filtrants ($B^l$), la dite autre cellule élémentaire de filtrage ($h_2^l$) est mise en parallèle de ladite première cellule élémentaire de filtrage ($h_1^l$) et comprend une deuxième cellule élémentaire de filtrage ($h_2^l$) issue d'une factorisation d'un deuxième filtre ARMA ($h_2$).

7. Procédé selon la revendication 6, dans lequel si l'une des factorisations des premier et deuxième filtres ARMA ($h_1$, $h_2$) comprend plus de cellules élémentaires de filtrage ($h_i^l$) que l'autre, une cellule filtre de type filtre identité (PTi) est associée à chaque cellule élémentaire de filtrage surnuméraire pour former un dit bloc filtrant ($B^l$).

**8.** Procédé selon la revendication 1, comprenant, en réponse à une deuxième demande de changement de filtrage inverse de la première demande et reçue lors du basculement progressif, une étape d'inversion dudit basculement de filtrage depuis l'état de basculement ($C_f(T_1)$, $C_0(T_1)$) correspondant à l'instant ($T_1$) de réception de ladite deuxième demande de changement.

**9.** Dispositif de filtrage (1) d'un signal numérique (x) à l'aide d'au moins un filtre ARMA ($h_1$, $h_2$), comprenant :

- une pluralité de premiers blocs filtrants ($B_1^l$, $B^l$) mis en cascade, comprenant chacun une première cellule élémentaire de filtrage ($h_1^l$) et une autre cellule élémentaire de filtrage (PT1, $h_2^l$) associée, l'ensemble desdites premières cellules élémentaires de filtrage ($h_1^l$) de la pluralité de premiers blocs filtrants ($B_1^l$, $B^l$) factorisant un premier filtre ARMA ($h_1$) ;

- au moins un élément de contrôle ($10_l^l$, $10^l_{PTl}$) pour commander, au niveau de chaque premier bloc filtrant ($B_1^l$, $B^l$), un changement de filtrage en réponse à une première demande de changement de filtrage vers ou depuis un filtrage par le premier filtre ARMA ($h_1$),

- et chaque dit premier bloc filtrant est configuré pour opérer le changement de filtrage par basculement progressif entre un filtrage de signal numérique ($\tilde{s}_i^{l-1}(n)$) par la première cellule élémentaire de filtrage et un filtrage de signal numérique ($\tilde{s}_i^{l-1}(n)$) par la dite autre cellule élémentaire de filtrage associée (PT1, $h_2^l$).

**10.** Dispositif (1) selon la revendication 9, dans lequel chaque dit premier bloc filtrant comprend un additionneur pour combiner un signal filtré par la première cellule élémentaire de filtrage ($h_1^l$) avec un signal filtré par la dite autre cellule élémentaire de filtrage associée (PT1, $h_2^l$). associée, de sorte à générer un signal de sortie mixée ($\tilde{s}_i^{l-1}(n)$) de bloc filtrant pendant le basculement progressif.

**11.** Dispositif (1) selon la revendication 10, dans lequel l'au moins un élément de contrôle comprend des moyens d'atténuation progressive ($10_l^l$, $10^l_{PTl}$) du signal filtré ($s_l$) par la première cellule élémentaire de filtrage ($h_1^l$) et du signal filtré ($s_l$) par la dite autre cellule élémentaire de filtrage associée (PT1, $h_2^l$). avant combinaison, selon respectivement deux coefficients complémentaires de fondu ($C_f$, $C_0$), l'un de fondu en fermeture et l'autre de fondu en ouverture.

**12.** Dispositif (1) selon la revendication 9, dans lequel au sein de chaque premier bloc filtrant ($B_1^l$) la dite autre cellule élémentaire de filtrage (PT1) est mise en parallèle de ladite première cellule élémentaire de filtrage ($h_1^l$) à laquelle est appliqué un coefficient de basculement et la dite autre cellule élémentaire de filtrage met en oeuvre un filtre identité (PT1) pondéré par un coefficient de basculement complémentaire ($10^l_{PRl}$, $C_f$, $C_0$).

**13.** Dispositif (1) selon la revendication 12, dans lequel ladite pluralité de premiers blocs filtrants ($B_1^l$) est mise en série d'une pluralité de deuxièmes blocs filtrants ($B_2^l$) en cascade comprenant, chacun, une deuxième cellule élémentaire de filtrage ($h_2^l$) issue d'une factorisation d'un deuxième filtre ARMA ($h_2$) mise en parallèle d'une cellule filtre identité (PT2) et pondérée par un coefficient de basculement, l'ensemble desdites deuxièmes cellules élémentaires de filtrage $(h_2^l)$ de la pluralité de deuxièmes blocs filtrants factorisant le deuxième filtre ARMA ($h_2$), et

le dispositif comprend, au niveau des deuxièmes blocs filtrants $(B_2^l)$, des éléments de contrôle ( $(10_2^l, 10_{PT2}^l)$ d'un basculement progressif de filtrage par les deuxièmes cellules élémentaires inverse du basculement progressif de filtrage par les premières cellules élémentaires au niveau des premiers blocs filtrants $(B_1^l)$, de sorte à contrôler un basculement progressif entre un filtrage par le premier filtre ARMA ($h_1$), et un filtrage par le deuxième filtre ARMA ($h_2$).

14. Dispositif (1) selon la revendication 9, dans lequel au sein desdits premiers blocs filtrants ($B^l$), la dite autre cellule élémentaire de filtrage ($h_2$). est mise en parallèle de ladite première cellule élémentaire de filtrage ($h_1$). et comprend une deuxième cellule élémentaire de filtrage $(h_2^l)$ issue d'une factorisation d'un deuxième filtre ARMA ($h_2$).

15. Produit programme d'ordinateur lisible par un microprocesseur, comprenant des instructions pour la mise en oeuvre du procédé de filtrage conforme à la revendication 1, lorsque ce programme est chargé et exécuté par le microprocesseur.

**Patentansprüche**

1. Verfahren zur Filterung eines digitalen Signals (x) mit Hilfe mindestens eines ARMA-Filters ($h_1$, $h_2$), umfassend einen Schritt des Empfangs eines ersten Antrags auf Änderung einer Filterung zu oder von einer Filterung durch einen ersten ARMA-Filter ($h_1$), **dadurch gekennzeichnet, dass** es als Antwort auf den ersten Antrag im Bereich jedes einer Vielzahl von ersten Filterblöcken ($B_1^1$, $B^1$), die kaskadenartig angeordnet sind, einen Schritt des progressiven Schwenkens zwischen einer Filterung eines digitalen Signals ($\tilde{s}_i^{1-1}(n)$) durch eine erste elementare Filterzelle ($h_1^1$), die aus einer Faktorisierung des ersten Filters ($h_1$) stammt, und einer Filterung eines digitalen Signals ($\tilde{s}_i^{1-1}(n)$) durch eine zugehörige andere elementare Filterzelle (PT1, $h_2^1$) umfasst, und bei dem die Gesamtheit der ersten elementaren Filterzellen ($h_1^1$) der Vielzahl von ersten Filterblöcken ($B_1^1$, $B^1$) den ersten ARMA-Filter ($h_1$) faktorisiert.

2. Verfahren nach Anspruch 1, bei dem das progressive Schwenken im Bereich eines ersten Filterblocks die Kombination eines durch die erste elementare Filterzelle ($h_1^1$) gefilterten Signals mit einem von der zugehörigen anderen elementaren Filterzelle (PT1, $h_2^1$) gefilterten Signal umfasst, um ein gemischtes Ausgangssignal ($\tilde{s}_i^{1-1}(n)$) eines Filterblocks während des progressiven Schwenkens zu erhalten.

3. Verfahren nach Anspruch 2, bei dem das progressive Schwenken Überblendungen einsetzt, deren entsprechende Überblendungskoeffizienten ($C_f$, $C_0$) an die von den ersten elementaren Filterzellen ($h_1^1$) und von den anderen elementaren Filterzellen (PT1, $h_2^1$) gefilterten Signale angelegt werden.

4. Verfahren nach Anspruch 2, bei dem innerhalb jedes ersten Filterblocks ($B_1^1$) die andere elementare Filterzelle (PT1) mit der ersten elementaren Filterzelle ($h_1^1$), an die ein Schwenkkoeffizient 25 angelegt wird, parallel geschaltet wird, und die andere elementare Filterzelle (PT1) einen Identitätsfilter (PT1) einsetzt, der durch einen komplementären Schwenkkoeffizienten ($10_{PT1}^1$, $C_f$, $C_0$) gewichtet wird.

5. Verfahren nach Anspruch 4, bei dem die Vielzahl von ersten Filterblöcken ($B_1^1$) mit einer Vielzahl von kaskadenartig angeordneten zweiten Filterblöcken ($B_2^1$) in Serie geschaltet wird, umfassend jeweils eine zweite elementare Filterzelle ($h_2^1$), die aus einer Faktorisierung eines zweiten ARMA-Filters ($h_2$) stammt und mit einer Identitätsfilterzelle (PT2) parallel geschaltet und durch einen Schwenkkoeffizienten gewichtet ist, wobei die Gesamtheit der zweiten elementaren Filterzellen ($h_2^1$) der Vielzahl von zweiten Filterblöcken den zweiten ARMA-Filter ($h_2$) faktorisiert, und wobei das Verfahren im Bereich der zweiten Filterblöcke ($B_2^1$) ein progressives Schwenken einer Filterung durch die zweiten elementaren Zellen umgekehrt zum progressiven Schwenken einer Filterung durch die ersten elementaren Zellen im Bereich der ersten Filterblöcke ($B_1^1$) umfasst, um ein progressives Schwenken zwischen einer Filterung durch den ersten ARMA-Filter ($h_1$) und einer Filterung durch den zweiten ARMA-Filter ($h_2$) zu kontrollieren.

6. Verfahren nach Anspruch 2, bei dem innerhalb der ersten Filterblöcke ($B^1$) die andere elementare Filterzelle ($h_2^1$) mit der ersten elementaren Filterzelle ($h_1^1$) parallel geschaltet wird und eine zweite elementare Filterzelle ($h_2^1$) umfasst, die aus einer Faktorisierung eines zweiten ARMA-Filters ($h_2$) stammt.

7. Verfahren nach Anspruch 6, bei dem, wenn eine der Faktorisierungen der ersten und zweiten ARMA-Filter ($h_1, h_2$) mehr elementare Filterzellen ($h_i^1$) als die andere umfasst, eine Filterzelle des Typs Identitätsfilter (PTi) jeder überzähligen elementaren Filterzelle zugeordnet wird, um einen Filterblock ($B^1$) zu bilden.

8. Verfahren nach Anspruch 1, umfassend als Antwort auf einen zweiten Antrag auf Änderung einer Filterung umgekehrt zum ersten Antrag und erhalten beim progressiven Schwenken einen Schritt der Umkehr des Schwenkens einer Filterung vom Schwenkzustand ($C_f (T_1), C_0(T_1)$) entsprechend dem Zeitpunkt ($T_1$) des Erhalts des zweiten Änderungsantrags.

9. Vorrichtung (1) zur Filterung eines digitalen Signals (x) mit Hilfe mindestens eines ARMA-Filters ($h_1, h_2$), umfassend:

   - eine Vielzahl von kaskadenartig angeordneten ersten Filterblöcken ($B_1^1, B^1$), jeweils umfassend eine erste elementare Filterzelle ($h_1^1$) und eine zugehörige andere elementare Filterzelle (PT1, $h_2^1$), wobei die Gesamtheit der ersten elementaren Filterzellen ($h_1^1$) der Vielzahl von ersten Filterblöcken ($B_1^1, B^1$) einen ersten ARMA-Filter ($h_1$) faktorisiert;
   - mindestens ein Kontrollelement ($10_1^1, 10_{PT1}^1$), um im Bereich jedes ersten Filterblocks ($B_1^1, B^1$) eine Änderung einer Filterung als Antwort auf einen ersten Antrag auf Änderung einer Filterung zu oder von einer Filterung durch den ersten ARMA-Filter ($h_1$) zu steuern,
   - und wobei jeder erste Filterblock derart konfiguriert ist, dass er die Änderung einer Filterung durch progressives Schwenken zwischen einer Filterung eines digitalen Signals ($\tilde{s}_i^{1-1}(n)$) durch die erste elementare Filterzelle und einer Filterung eines digitalen Signals ($\tilde{s}_i^{1-1}(n)$) durch die zugehörige andere elementare Filterzelle (PT1, $h_2^1$) durchführt.

10. Vorrichtung (1) nach Anspruch 9, bei der jeder erste Filterblock ein Addierelement umfasst, um ein von der ersten elementaren Filterzelle ($h_1^1$) gefiltertes Signal mit einem von der zugehörigen anderen elementaren Filterzelle (PT1, $h_2^1$) gefilterten Signal zu kombinieren, um ein gemischtes Ausgangssignal ($\tilde{s}_i^{1-1}(n)$) eines Filterblocks während des progressiven Schwenkens zu erzeugen.

11. Vorrichtung (1) nach Anspruch 10, bei der das mindestens eine Kontrollelement Mittel zur progressiven Dämpfung ($10_1^1, 10_{PT1}^1$) des von der ersten elementaren Filterzelle ($h_1^1$) gefilterten Signals ($s_i^1$) und des von der zugehörigen anderen elementaren Filterzelle (PT1, $h_2^1$) gefilterten Signals ($s_i^1$) vor der Kombination gemäß jeweils zwei komplementären Überblendungskoeffizienten ($C_f, C_0$), einem der Überblendung beim Schließen und dem anderen der Überblendung beim Öffnen, umfasst.

12. Vorrichtung (1) nach Anspruch 9, bei der innerhalb jedes ersten Filterblocks ($B_1^1$) die andere elementare Filterzelle (PT1) mit der ersten elementaren Filterzelle ($h_1^1$), an die ein Schwenkkoeffizient angelegt wird, parallel geschaltet wird, und die andere elementare Filterzelle (PT1) einen Identitätsfilter (PT1) einsetzt, der durch einen komplementären Schwenkkoeffizienten ($10_{PT1}^1, C_f, C_0$) gewichtet wird.

13. Vorrichtung (1) nach Anspruch 12, bei der die Vielzahl von ersten Filterblöcken ($B_1^1$) mit einer Vielzahl von kaskadenartig angeordneten zweiten Filterblöcken ($B_2^1$) in Serie geschaltet wird, umfassend jeweils eine zweite elementare Filterzelle ($h_2^1$), die aus einer Faktorisierung eines zweiten ARMA-Filters ($h_2$) stammt und mit einer Identitätsfilterzelle (PT2) parallel geschaltet und durch einen Schwenkkoeffizienten gewichtet ist, wobei die Gesamtheit der zweiten elementaren Filterzellen ($h_2^1$) der Vielzahl von zweiten Filterblöcken den zweiten ARMA-Filter ($h_2$) faktorisiert, und wobei die Vorrichtung im Bereich der zweiten Filterblöcke ($B_2^1$) Kontrollelemente ($10_2^1, 10_{PT2}^1$) eines progressiven Schwenkens einer Filterung durch die zweiten elementaren Zellen umgekehrt zum progressiven Schwenken einer Filterung durch die ersten elementaren Zellen im Bereich der ersten Filterblöcke ($B_1^1$) umfasst, um ein progressives Schwenken zwischen einer Filterung durch den ersten ARMA-Filter ($h_1$) und einer Filterung durch den zweiten ARMA-Filter ($h_2$) zu kontrollieren.

14. Vorrichtung (1) nach Anspruch 9, bei der innerhalb der ersten Filterblöcke ($B^1$) die andere elementare Filterzelle ($h_2$) mit der ersten elementaren Filterzelle ($h_1$) parallel geschaltet wird und eine zweite elementare Filterzelle ($h_2^1$) umfasst, die aus einer Faktorisierung eines zweiten ARMA-Filters ($h_2$) stammt.

**15.** Computerprogrammprodukt, das von einem Mikroprozessor lesbar ist, umfassend Befehle für den Einsatz des Filterverfahrens nach Anspruch 1, wenn dieses Programm geladen ist und vom Mikroprozessor ausgeführt wird.

**Claims**

**1.** Method of filtering a digital signal (x) with the aid of at least one ARMA filter ($h_1$, $h_2$), comprising a step of receiving a first request for change of filtering to or from a filtering by a first ARMA filter ($h_1$), **characterized in that** it comprises, in response to said first request, a step of progressive switching, at the level of each of a plurality of first filtering blocks ($B_1^{\ell}$,$B^{\ell}$) placed in cascade, between a digital signal filtering ($\tilde{s}_i^{\,\ell-1}(n)$) by a first elementary filtering cell ($h_1^{\ell}$) arising from a factorization of the first filter ($h_1$) and a digital signal filtering ($\tilde{s}_i^{\,\ell-1}(n)$) by an associated other elementary filtering cell (PT1, $h_2^{\ell}$), and
in which the set of said first elementary filtering cells ($h_1^{\ell}$) of the plurality of first filtering blocks ($B_1^{\ell}$,$B^{\ell}$) factorizes said first ARMA filter ($h_1$).

**2.** Method according to Claim 1, in which the progressive switching at the level of a first filtering block comprises the combining of a signal filtered by the first elementary filtering cell ($h_1^{\ell}$) with a signal filtered by the associated other elementary filtering cell (PT1, $h_2^{\ell}$), so as to obtain a mixed output signal ($\tilde{s}_i^{\,\ell-1}(n)$) of a filtering block during the progressive switching.

**3.** Method according to Claim 2, in which said progressive switching implements fades whose corresponding fade coefficients ($C_f$, $C_0$ are applied to the signals filtered by the first elementary filtering cells ($h_1^{\ell}$) and by the other elementary filtering cells (PT1, $h_2^{\ell}$).

**4.** Method according to Claim 2, in which within each first filtering block ($B_1^{\ell}$), said other elementary filtering cell (PT1) is placed in parallel with said first elementary filtering cell ($h_1^{\ell}$) to which is applied a switching coefficient, 25 and said other elementary filtering cell (PT1) implements an identity filter (PT1) weighted by a complementary switching coefficient ($10^{\ell}_{PT1}$, $C_f$, $C_0$).

**5.** Method according to Claim 4, in which said plurality of first filtering blocks ($B_1^{\ell}$) is placed in series with a plurality of second filtering blocks ($B_2^{\ell}$) in cascade, each comprising a second elementary filtering cell ($h_2^{\ell}$) arising from a factorization of a second ARMA filter ($h_2$) placed in parallel with an identity filter cell (PT2) and weighted by a switching coefficient, the set of said second elementary filtering cells ($h_2^{\ell}$) of the plurality of second filtering blocks factorizing the second ARMA filter ($h_2$), and
the method comprises, at the level of the second filtering blocks ($B_2^{\ell}$), a progressive switching of a filtering by the second elementary cells which is inverse to the progressive switching of filtering by the first elementary cells at the level of the first filtering blocks ($B_1^{\ell}$), so as to control a progressive switching between a filtering by the first ARMA filter ($h_1$) and a filtering by the second ARMA filter ($h_2$).

**6.** Method according to Claim 2, in which within said first filtering blocks ($B^{\ell}$), said other elementary filtering cell ($h_2^{\ell}$) is placed in parallel with said first elementary filtering cell ($h_1^{\ell}$) and comprises a second elementary filtering cell ($h_2^{\ell}$) arising from a factorization of a second ARMA filter ($h_2$).

**7.** Method according to Claim 6, in which if one of the factorizations of the first and second ARMA filters ($h_1$, $h_2$) comprises more elementary filtering cells ($h_i^{\ell}$) than the other, a filter cell of identity filter type (PTi) is associated with each supernumerary elementary filtering cell to form a said filtering block ($B^{\ell}$).

**8.** Method according to Claim 1, comprising, in response to a second request for change of filtering inverse to the first request and received during the progressive switching, a step of inverting said switching of filtering from the switching state ($C_f(T_1)$, $C_0(T_1)$) corresponding to the instant ($T_1$) of reception of said second request for change.

**9.** Device (1) for filtering a digital signal (x) with the aid of at least one ARMA filter ($h_1$, $h_2$), comprising:

- a plurality of first filtering blocks ($B_1^{\ell}$, $B^{\ell}$) placed in cascade, each comprising a first elementary filtering cell ($h_1^{\ell}$) and an associated other elementary filtering cell (PT1, $h_2^{\ell}$), the set of said first elementary filtering cells ($h_1^{\ell}$) of the plurality of first filtering blocks ($B_1^{\ell}$,$B^{\ell}$) factorizing a first ARMA filter ($h_1$) ;
- at least one control element ($10_1^{\ell}$, $10^{\ell}_{PT1}$) for commanding, at the level of each first filtering block ($B_1^{\ell}$,$B^{\ell}$), a change of filtering in response to a first request for change of filtering to or from a filtering by the first ARMA

filter ($h_1$),

- and each said first filtering block is configured to operate the change of filtering by progressive switching between a digital signal filtering ($\tilde{s}_i^{l-1}(n)$) by the first elementary filtering cell and a digital signal filtering ($\tilde{s}_i^{l-1}(n)$) by said associated other elementary filtering cell (PT1, $h_2^{\ell}$).

10. Device (1) according to Claim 9, in which each said first filtering block comprises an adder for combining a signal filtered by the first elementary filtering cell ($h_1^{\ell}$) with a signal filtered by said associated other elementary filtering cell (PT1, $h_2^{\ell}$), so as to generate a mixed output signal ($\tilde{s}_i^{l-1}(n)$) of a filtering block during the progressive switching.

11. Device (1) according to Claim 10, in which the at least one control element comprises means of progressive attenuation ($10_1^{\ell}$, $10^{\ell}_{PT1}$) of the signal filtered ($s_i^{\ell}$) by the first elementary filtering cell ($h_1^{\ell}$) and of the signal filtered ($s_i^{\ell}$) by said associated other elementary filtering cell (PT1, $h_2^{\ell}$) before combining, according respectively to two complementary fade coefficients ($C_f$, $C_0$), one of closing fade and the other of opening fade.

12. Device (1) according to Claim 9, in which within each first filtering block ($B_1^{\ell}$), said other elementary filtering cell (PT1) is placed in parallel with said first elementary filtering cell ($h_1^{\ell}$) to which is applied a switching coefficient and said other elementary filtering cell implements an identity filter (PT1) weighted by a complementary switching coefficient ($10^{\ell}_{PT1}$, $C_f$, $C_0$).

13. Device (1) according to Claim 12, in which said plurality of first filtering blocks ($B_1^{\ell}$) is placed in series with a plurality of second filtering blocks ($B_2^{\ell}$) in cascade, each comprising a second elementary filtering cell ($h_2^{\ell}$) arising from a factorization of a second ARMA filter ($h_2$) placed in parallel with an identity filter cell (PT2) and weighted by a switching coefficient, the set of said second elementary filtering cells ($h_2^{\ell}$) of the plurality of second filtering blocks factorizing the second ARMA filter ($h_2$), and

the device comprises, at the level of the second filtering blocks ($B_2^{\ell}$), control elements ($10_2^{\ell}$, $10^{\ell}_{PT2}$) for a progressive switching of filtering by the second elementary cells which is inverse to the progressive switching of filtering by the first elementary cells at the level of the first filtering blocks ($B_1^{\ell}$), so as to control a progressive switching between a filtering by the first ARMA filter ($h_1$) and a filtering by the second ARMA filter ($h_2$).

14. Device (1) according to Claim 9, in which within said first filtering blocks ($B^{\ell}$), said other elementary filtering cell ($h_2$) is placed in parallel with said first elementary filtering cell ($h_1$) and comprises a second elementary filtering cell ($h_2^{\ell}$) arising from a factorization of a second ARMA filter ($h_2$).

15. Computer program product readable by a microprocessor, comprising instructions for the implementation of the method of filtering in accordance with Claim 1, when this program is loaded and executed by the microprocessor.

Figure 1

Figure 2

Figure 2a

Figure 2b

Figure 3

Figure 4

Figure 5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4706291 A

**Littérature non-brevet citée dans la description**

- The Volterra and Wiener theories of nonlinear systems. Krieger, 1989
- **ZETTERBERG, L.H. ; Q. ZHANG.** Elimination of transients in adaptive filters with application to speech coding'' de Zetterberg. *Elimination of transients in adaptive filters with application to speech coding,* 1988
- **DE VERHELST, W. ; P. NILENS.** *A modified-superposition speech synthesizer and its applications,* 1986